(19) Europäisches Patentamt
European Patent Office
Office européen des brevets

(11) Veröffentlichungsnummer: **0 062 197**
**A2**

# (12) EUROPÄISCHE PATENTANMELDUNG

(21) Anmeldenummer: **82102263.9**

(22) Anmeldetag: **19.03.82**

(51) Int. Cl.³: **G 03 F 7/08**, G 03 F 1/00

(30) Priorität: **08.04.81 DE 3114163**

(43) Veröffentlichungstag der Anmeldung: **13.10.82**
**Patentblatt 82/41**

(84) Benannte Vertragsstaaten: **AT BE CH DE FR GB IT LI NL**

(71) Anmelder: **RENKER GmbH & Co. KG,**
**Kreuzauerstrasse 33, D-5160 Düren-Niederau (DE)**

(72) Erfinder: **Frenzel, Robert, Marie Juchaczstrasse 9,**
**D-5160 Düren (DE)**

## (54) Umkehrender photomechanischer Abziehfilm.

(57) Die Erfindung betrifft einen umkehrend arbeitenden photomechanischen Abziehfilm, der aus einer flexiblen Unterlage, einer ersten Schicht aus einem alkohollöslichen Polyamid und einer zweiten lichtempfindlichen Schicht besteht, wobei die lichtempfindliche Schicht aus wenigstens einem Polymeren aus der aus Polyvinylacetat, einem Copolymeren des Vinylacetats mit Comonomeren wie Vinylpyrrolidon oder Carbonsäuren wie Crotonsäure oder Maleinsäure, oder den Estern dieser Säure, oder einem Celluloseacetatderivat, dessen Acetylierungsgrad unterhalb dem des Triacetats liegt, bestehenden Gruppe, im Gemisch mit wenigstens einem p-Benzochinondiazid besteht.

Ein solcher Abziehfilm läßt sich mit einer wässrigen Natriumsalicylatlösung, die keine organischen Lösungsmittel und kein Alkali enthält, gleichzeitig entwickeln und ätzen.

EP 0 062 197 A2

Renker GmbH & Co.KG
516 Düren-Niederau

kl/kf-RA 1868
15. 3. 1982

# Umkehrender photomechanischer Abziehfilm

Die Erfindung betrifft einen bildumkehrenden photomechanischen Abziehfilm.

Ein photomechanischer Abziehfilm besteht bekanntlich aus einer Unterlage bzw. einem Träger aus einem flexiblen, flächenförmigen Material (z.B. einer Kunststoffolie), einer auf der Unterlage angeordneten ersten Schicht, die durch geeignete Mittel aufgelöst oder weggeätzt werden kann und einer über der ersten Schicht liegenden zweiten Schicht, die lichtempfindlich ist.

Aus der DE-OS 20 23 083 ist bereits ein solcher photomechanischer Abziehfilm bekannt, dessen Unterlage aus einer transparenten Polyesterfolie besteht, auf der eine erste Schicht aus einem filmbildenden alkohollöslichen Polyamid aufgebracht ist, über der eine zweite lichtempfindliche Schicht liegt, die ein Naphtochinondiazid als lichtempfindliches Material enthält. Ein solcher Film muß jedoch zunächst nach der Belichtung mit einer wässrigen alkalischen Lösung entwickelt werden, um, da die

lichtempfindliche Schicht positiv arbeitet, die belichteten Stellen wegzulösen. Erst nach der Entwicklung kann dann in einer zweiten Stufe die freigelegte erste Schicht aus filmbildendem Polyamid mit einer wässrigen Lösung von Natriumsalicylat, Chloralhydrat oder Bromalhydrat, die noch geringe Mengen an Methanol, Äthanol, Benzylalkohol oder Furfurol zur Verbesserung der Fließeigenschaft enthält weggeätzt werden.

Aus der DE-OS 30 08 824 ist es auch bereits bekannt, einen photomechanischen Abziehfilm, dessen erste Schicht aus einem alkohollöslichen Polyamid und dessen lichtempfindliche Schicht Orthochinondiazidverbindungen, Monoazidverbindungen und Bisazidverbindungen, gegebenenfalls im Gemisch oder als Reaktionsprodukt mit einem Harz, wie einem Phenolformalinharz, enthält, einstufig mit einer wässrigen Lösung, die 12-70 Gewichtsprozent eines aromatischen Neutralsalzes, 0,01-10 Gewichtsprozent Alkali und 1-15 Gewichtsprozent eines Alkohols enthält, gleichzeitig zu entwickeln und zu ätzen.
Zwar wird hierdurch eine Vereinfachung erzielt, jedoch enthält die Lösung noch immer Alkali und Alkohol; sowohl aus Gesundheitsgründen als auch im Hinblick auf den Umweltschutz wären aber rein wässrige Lösungen, die keine organischen Lösungsmittel und keine aggressiven Chemikalien wie Alkali enthalten, vorzuziehen.

Aufgabe der Erfindung ist daher die Schaffung eines umkehrend arbeitenden photomechanischen Abziehfilms, der sich einfach und umweltfreundlich mit einer rein wässrigen Lösung, die keine organischen Lösungsmittel und kein Alkali enthält, gleichzeitig entwickeln und ätzen lässt.

Diese Aufgabe wird erfindungsgemäß durch eine lichtempfindliche Schicht gelöst, die aus einem Gemisch aus wenigstens einem Polymeren aus der aus

1. Polyvinylacetat,
2. Copolymeren des Vinylacetats mit damit copolymerisierbaren Monomeren, bevorzugt Vinylpyrrolidon oder ungesättigten Säuren oder deren Derivaten,
3. Celluloseacetaten mit einem Acetylierungsgrad, der niedriger als der des Triacetats ist

bestehenden Gruppe und wenigstens einem p-Benzochinondiazid besteht.

Der Erfindung liegt die überraschende Erkenntnis zugrunde, daß die vorstehend aufgeführten speziellen Polymeren in wässriger Natriumsalicylatlösung löslich sind und bei Belichtung mit UV-Licht mit der p-Benzochinondiazidverbindung ein in wässriger Natriumsalicylatlösung unlösliches Reaktionsprodukt bilden, wobei die Natriumsalicylatlösung gleichzeitig als Lösungsmittel für das Wegätzen der unter der lichtempfindlichen Schicht liegenden Polyamidschicht dient.

Gegenstand der Erfindung ist also ein umkehrend arbeitender photomechanischer Abziehfilm, bestehend aus

a. einer flexiblen Unterlage,
b. einer ersten Schicht aus einem alkohollöslichen Polyamid und
c. einer zweiten lichtempfindlichen Schicht,

der dadurch gekennzeichnet ist, daß die zweite lichtempfindliche Schicht c. aus einem Gemisch besteht, das

A. wenigstens ein Polymeres aus der aus
   1. Polyvinylacetat
   2. Copolymeren des Vinylacetats mit damit copolymerisierbaren Monomeren, bevorzugt Vinylpyrrolidon oder ungesättigten Carbonsäuren oder deren Derivaten, insbesondere Crotonsäure oder

Maleinsäure oder deren Estern

3. Celluloseacetaten mit einem Acetylierungsgrad, der kleiner als der des Triacetats ist

bestehenden Gruppe und

B. wenigstens ein p-Chinondiazid enthält.

Als Polyvinylacetat können die im Handel erhältlichen Produkte der verschiedenen Hersteller eingesetzt werden. Als Beispiel für geeignete Polyvinylacetate sind die unter der Bezeichnung "Mowilithe" (Hersteller Hoechst AG) und "GELVA" (Hersteller Monsanto) erhältlichen Produkte zu nennen. Das verwendete Polyvinylacetat soll noch hinreichend löslich sein, um bei Aufbringen der Mischung aus Polyvinylacetat und p-Benzochinondiazid aus der Lösung noch ein ausreichendes Beschichtungsgewicht zu erzielen. Als geeignet erwiesen haben sich beispielsweise Polyvinylacetate der Handelsbezeichnungen Mowilith 20 bis Mowilith 50. Als Copolymere des Vinylacetats mit copolymerisierbaren Monomeren werden solche mit einem Gehalt an Comonomeren von nicht mehr als 20, vorzugsweise nicht mehr als 10 % bevorzugt. Geeignete Copolymere enthalten als Comonomere Vinylpyrrolidon oder als ungesättigte Säuren Crotonsäure oder Maleinsäure oder deren Ester. Ebenso geeignet sind teilweise hydrolisierte Polyvinylacetate. Als Celluloseacetate sind Produkte mit einem Acetylierungsgrad geeignet, der unter dem des Triacetats liegt.
Die vorstehend genannten Polymeren können allein oder im Gemisch untereinander verwendet werden.

Lichtempfindliche für die Zwecke der Erfindung geeignete p-Benzochinondiazide und p-Iminobenzochinondiazide sind bekannt und beispielsweise in den US-PS 3 527 604 und 3 180 732 beschrieben. Sie haben die allgemeinen Formeln

$$O = R = N_2 \quad \text{bzw.} \quad R' - N = R = N_2$$

worin R für einen gegebenenfalls substituierten, von Benzol abgeleiteten chinoiden Ring steht und R' einen gegebenenfalls substituierten Aryl- oder Acrylrest, z.B. einen Arylsulfonylrest bedeutet.

Falls der Chinonring R substituiert ist, handelt es sich dabei bevorzugt um einen Substituenten R'' der allgemeinen Formel $-SO_2-X$, worin X entweder für die Gruppierung -NH-Y oder -N) steht. Y ist ein ein- oder mehrkerniger, gegebenenfalls substituierter aromatischer Rest oder ein heterocyclischer Rest. Beispiele für die Gruppierung -NH-Y sind der 2,5-Dimethylphenylaminorest und der 2-Äthylphenylaminorest. Als Beispiel für einen mehrkernigen aromatischen Rest sei der Naphtylrest genannt. Bevorzugt ist der Chinonring in 2-Stellung, d.h. in Nachbarstellung zum Sauerstoff bzw. Iminostickstoff substituiert.

Steht Y in der Gruppierung -NH-Y für einen heterocyclischen Rest, so ist dieser bevorzugt ein Pyrridinrest. Steht X für die Gruppierung -N) , so handelt es sich um eine heterocyclische Verbindung, die mit ihrem Stickstoffatom an die $SO_2$-Gruppe gebunden ist.
Beispiele hierfür sind der Pyrrolidon- und der Morpholinring. Besonders geeignet sind mehrkernige p-Benzo- bzw. p-Iminobenzochinondiazide.

Die erste Schicht besteht aus einem filmbildenden alkohollöslichen Polyamid, das zugleich auch in wässrigem Natriumsalicylat löslich sein muß. Geeignet sind hierfür in erster Linie die Copolyamide, z.B. Nylon 6/66, Nylon 6/66/610, Nylon 6/66/610/612, die nach bekannten Verfahren erhalten werden. Besonders bevorzugt sind die Mischpolymerisate von Hexamethylendiamin mit Adipinsäure, Sebacinsäure, sauren Oxidationsprodukten von Ölsäure und/oder Caprolactam.

Ebenfalls gut geeignet ist ein methoxymethyliertes Polyamid aus Adipinsäure und Hexamethylendiamin. Das Hexamethylendiamin kann in den vorstehend beschriebenen Mischpolymerisaten ganz oder teilweise durch ein p,p' Diaminodicyclohexylmethan ersetzt sein. Geeignet sind selbstverständlich auch Gemische der vorstehend beschriebenen Mischpolymerisate untereinander.

Die Polyamidschicht kann Farbstoffe oder Pigmente enthalten.

Als Unterlage werden bevorzugt transparente Platten, Folien oder Filme aus Kunststoffen wie Polyester, z.B. Polyäthylenterephthalat, Polypropylen, Polystyrol oder Celluloseacetat eingesetzt.
Auch Glas kann als Unterlage verwendet werden. Folien und Filme aus Polyester sind besonders bevorzugt, da sie maßstabil sind und eine glatte und undurchlässige Oberfläche aufweisen, von der sich die nicht abgeätzten Teile der Polyamidschicht leicht abziehen lassen.

Der erfindungsgemäße Film wird hergestellt, indem in bekannter Weise zunächst auf die als Unterlage dienende Trägerfolie aus Kunststoff die erste Schicht aus alkohollöslichem Polyamid, bevorzugt aus einer alkoholischen Lösung, aufgebracht wird, worauf anschließend die lichtempfindliche Schicht aus einem geeigneten Lösungsmittelsystem, das weder das Polyamid der ersten Schicht noch die gegebenenfalls darin eingelagerten Farbstoffe herauslösen darf, aufgestrichen wird.

Für praktische Zwecke werden Mischungen für die lichtempfindliche Schicht von 25 bis 50 % Polymeres, Rest zu 100 Chinondiazid, bezogen auf Trockengewicht, verwendet.

Das Beschichtungsgewicht der lichtempfindlichen Schicht ist variabel und kann zwischen 2 und 8 $g/m^2$ liegen. Als Lösungsmittel für die lichtempfindliche Schicht sind in erster Linie Gemische geeignet, die als eine Komponente Dimethylformamid, Dimethylsulfoxid, Cyclohexanon oder Aceton und als zweite Komponente einen niederen Alkylester, bevorzugt ein Alkylacetat, Diäthylacetat oder Methyläthylketon enthalten.

Nach dem Belichten wird der Film dann mit einer wässrigen Natriumsalicylatlösung entwickelt und geätzt. Die Konzentration der Lösung ist nicht kritisch. Nach oben ist die Konzentration durch die Sättigungsgrenze begrenzt. Wird eine stark verdünnte Lösung angewendet, dauert die Entwicklung/Ätzung länger.

Die Erfindung wird durch die folgenden Beispiele erläutert:

Beispiel 1

Eine 175 µm dicke Polyäthylenterephthalatfolie wurde mit folgendem Polyamidlack beschichtet, wobei die Filmstärke in getrocknetem Zustand 15 µm betrug:
(alle Teile sind Gewichtsteile)

130 Teile Methanol
10 Teile Solvent orange 27
2 Teile Basic violet 16
50 Teile alkohollösliches Polyamid auf der Grundlage von Caprolactam (33,3 %) Hexamethylendiamin/Adipinsäure (33,3 %) und p,p'Diaminodicyclohexylmethan/Adipinsäure (33,3 %)

Auf diese Schicht wurde folgende Mischung mit einem Trockengewicht von 5 $g/m^2$ aufgebracht:

27 Teile Äthylacetat
11 Teile Dimethylformamid
4 Teile Polyvinylacetat (Mowilith 50)
4 Teile p-Iminochinondiazid (Rohner 130)

Das so hergestellte Reproduktionsmaterial wurde 2 Minuten unter dem Positiv einer Strichzeichnung mit einer 3000 W MH-Lampe in einem Abstand von 80 cm belichtet.
Das belichtete Material wurde mit einem mit folgender Lösung getränkten Lammfelltampon überrieben:

100 Teile Wasser
60 Teile Na-salicylat

An den unbelichteten Stellen wurde sowohl der Photolack als auch die darunterliegende Polyamidschicht sauber herausgelöst. Das erhaltene Material stellte das Negativ der als Original verwendeten Strichzeichnung dar. Die auf dem Trägermaterial verbliebenen Schichtteile ließen sich leicht strippen.

Beispiel 2

Auf die gemäß Beispiel 1 mit einer ersten Schicht beschichtete Trägerfolie wurde folgende Mischung mit einem Trockengewicht von 5 $g/m^2$ aufgestrichen:

27 Teile Äthylacetat
11 Teile Dimethylformamid
4 Teile Polyvinylacetat/Crotonsäure/Copolymer (Mowilith Ct 5)
4 Teile p-Iminochinondiazid (Rohner 130)

Beispiel 3

Auf die gemäß Beispiel 1 beschichtete Trägerfolie wird eine lichtempfindliche Schicht mit einem Trockengewicht von 7 $g/m^2$ aus folgender Mischung aufgestrichen:

20 Teile Äthylacetat
12,5 Teile Dimethylformamid
2 Teile Polyvinylacetat/Vinylpyrrolidon/Copolymer mit 20 % Polyvinylpyrrolidon (GAF PVP/VA I 235)
5 Teile p-Iminochinondiazid (Rohner 130)

Beispiel 4

Auf eine gemäß Beispiel 1 beschichtete Trägerfolie, die jedoch als Farbstoffe 10 Teile Solvent orange 27 und 2 Teile Solvent red 127 enthielt, wurde eine lichtempfindliche Schicht eines Trockengewichts von 3 $g/m^2$ aus folgender Mischung aufgebracht:

30 Teile Methyläthylketon
12 Teile Dimethylformamid
4 Teile Celluloseacetat (CA 398-3, Eastman)
4 Teile p-Iminochinondiazid (Rohner 130)

Das nach den Beispielen 2 bis 4 hergestellte Reproduktionsmaterial wurde auf die in Beispiel 1 beschriebene Weise belichtet und anschließend gleichzeitig entwickelt und geätzt. An den unbelichteten Stellen wurde sowohl der Photolack als auch die darunterliegende Polyamidschicht herausgelöst, wobei ein Negativ der als Original verwendeten Strichzeichnung erhalten wurde.

## Patentansprüche

1. Umkehrend arbeitender photomechanischer Abziehfilm, bestehend aus

   a. einer flexiblen Unterlage,
   b. einer ersten Schicht aus einem alkohollöslichen Polyamid und
   c. einer zweiten lichtempfindlichen Schicht,

   dadurch gekennzeichnet, daß die zweite lichtempfindliche Schicht c. aus einem Gemisch besteht, das

   A. wenigstens ein Polymeres aus der aus

      1. Polyvinylacetat
      2. einem Copolymeren des Vinylacetats mit damit copolymerisierbaren Monomeren, bevorzugt Vinylpyrrolidon oder ungesättigten Carbonsäuren oder deren Derivaten, insbesondere Crotonsäure oder Maleinsäure oder deren Estern,
      3. Celluloseacetaten mit einem Acetylierungsgrad, der kleiner als der des Triacetats ist

      bestehenden Gruppe und

   B. wenigstens ein p-Chinondiazid enthält.

2. Abziehfilm nach Anspruch 1, dadurch gekennzeichnet, daß die lichtempfindliche Schicht c. eine mehrkernige p-Chinondiazidverbindung enthält.

3. Abziehfilm nach einem der Ansprüche 1 bis 2, dadurch gekennzeichnet, daß die lichtempfindliche Schicht c. ein p-Iminochinondiazid enthält.

4. Abziehfilm nach Anspruch 1 bis 3, dadurch gekennzeichnet, daß die lichtempfindliche Schicht c. ein

Copolymeres von Vinylacetat enthält, das zu wenigstens 80 % aus Vinylacetatgrundeinheiten besteht.

5. Abziehfilm nach einem der Ansprüche 1 bis 4, dadurch gekennzeichnet, daß die lichtempfindliche Schicht c. ein Copolymeres von Vinylacetat mit Vinylpyrrolidon oder einer ungesättigten Säure oder einem Derivat dieser Säure enthält.

6. Abziehfilm nach einem der Ansprüche 1 bis 5, dadurch gekennzeichnet, daß die lichtempfindliche Schicht ein Copolymeres von Vinylacetat mit Crotonsäure oder Maleinsäure oder einem Ester von Croton- oder Maleinsäure enthält.

7. Abziehfilm nach einem der Ansprüche 1 bis 6, dadurch gekennzeichnet, daß die lichtempfindliche Schicht ein Celluloseacetat mit einem Essigsäureanteil von nicht mehr als 60, bevorzugt nicht mehr als 55 % enthält.

8. Abziehfilm nach einem der Ansprüche 1 bis 7, dadurch gekennzeichnet, daß die lichtempfindliche Schicht ein mehrkerniges p-Iminochinondiazid enthält.

9. Abziehfilm nach einem der Ansprüche 1 bis 8, dadurch gekennzeichnet, daß die erste Schicht aus einem in Alkohol und in wässriger Natriumsalicylatlösung löslichen Polyamid besteht.

10. Abziehfilm nach Anspruch 9, dadurch gekennzeichnet, daß die erste Schicht aus einem Mischpolymerisat von Hexamethylendiamin mit Adipinsäure, Sebacinsäure, Caprolactam und/oder p,p'Diaminodicyclohexylmethan besteht.